**Europäisches Patentamt**

**European Patent Office**

**Office européen des brevets**

(19)

(11) Veröffentlichungsnummer : **0 076 400**
**B1**

(12) **EUROPÄISCHE PATENTSCHRIFT**

(45) Veröffentlichungstag der Patentschrift :
05.06.85

(21) Anmeldenummer : 82108508.1

(22) Anmeldetag : 15.09.82

(51) Int. Cl.⁴ : **G 01 N 24/08, A 61 B 5/05**

(54) **Gerät zur Erzeugung von Bildern eines Untersuchungsobjektes.**

(30) Priorität : 01.10.81 DE 3139137

(43) Veröffentlichungstag der Anmeldung :
13.04.83 Patentblatt 83/15

(45) Bekanntmachung des Hinweises auf die Patenterteilung : 05.06.85 Patentblatt 85/23

(84) Benannte Vertragsstaaten :
**GB NL**

(56) Entgegenhaltungen :
**EP-A- 0 009 288**
**EP-A- 0 024 640**
**GB-A- 2 037 996**
**JOURNAL OF PHYSICS E: SCIENTIFIC INSTRUMENTS, Band 13, Juli 1980, Seiten 747-750, London, G.B. C.M. LAI et al.: "A gradient control device for complete three-dimensional nuclear magnetic resonance zeugmatographic imaging"**
**JOURNAL OF PHYSICS E: SCIENTIFIC INSTRUMENTS, Band 14, Nr. 9, September 1981, Seiten 1052-1053, London, G.B. P.A. BOTTOMLEY: "Digital gradient magnetic field reorientation in three-dimensional NMR zeugmatography"**

(73) Patentinhaber : **Siemens Aktiengesellschaft Berlin und München Wittelsbacherplatz 2 D-8000 München 2 (DE)**

(72) Erfinder : **Riedl, Hermann Dechsendorfer Strasse 6 D-8520 Erlangen (DE)**

## Beschreibung

Die Erfindung betrifft ein Gerät zur Erzeugung von Bildern eines Untersuchungsobjektes mit magnetischer Kernspinresonanz, bei dem Mittel zum Anlagen von Magnetfeldern an das Untersuchungsobjekt und Mittel zum Erfassen der Auslenkung der Kernspins des Untersuchungsobjektes aus ihrer Gleichgewichtslage durch einen hochfrequenten magnetischen Anregungsimpuls vorhanden sind und bei dem die Mittel zum Anlagen von Magnetfeldern Gradientenspulen aufweisen, die von einer Steuervorrichtung gespeist werden und die Lage einer untersuchten Schicht im Untersuchungsobjekt in bezug auf ein dreidimensionales Koordinatensystem mit einer x-, y- und z-Achse festlegen.

Bei einem Gerät dieser Art, das z. B. im J. Phys. E, Band 13, 1980, Seiten 747 bis 750 beschrieben ist, wird die Tatsache ausgenutzt, daß die Atomkerne bestimmter Elemente, insbesondere von Wasserstoff, in einem statischen Magnetfeld ausgerichtet und durch einen hochfrequenten magnetischen Anregungsimpuls aus ihrer Vorzugsrichtung auslenkbar sind, in die sie nach dem Ende des Anregungsimpulses wieder zurückkehren. Während der Rückkehr führen sie eine Präzessionsbewegung um die Vorzugslage aus. Die dadurch in einer Meßspule erzeugte Information hat eine Frequenz, die von der magnetischen Flußdichte abhängt.

Es ist auch möglich, eine selektive Anregung einer bestimmten Schicht des Untersuchungsobjektes dadurch zu erzielen, daß man die Tatsache ausnutzt, daß für die Anregung von Atomkernen eine bestimmte Frequenz erforderlich ist, die von der magnetischen Flußdichte abhängig ist. Wird dem Magnetfeld zum Ausrichten der Atomkerne ein Feldgradient überlagert, so werden nur die Atomkerne in einer bestimmten Schicht des Untersuchungsobjektes angeregt, in der die magnetische Flußdichte der Frequenz des Anregungsimpulses entspricht.

Es ist bekannt, daß man durch geeignete Anordnung von Gradientenspulen Gradienten-Vektoren erzeugen kann, die durch Linearkombination einen beliebig orientierten Summenvektor und damit eine beliebige Schicht im Untersuchungsobjekt ergeben. Für die Auswahl einer im Untersuchungsobjekt beliebig liegenden Schicht ist dabei aber ein relativ großer Aufwand an Elektronik in der Steuervorrichtung für die Gradientenspulen erforderlich.

Der Erfindung liegt die Aufgabe zugrunde, ein Gerät der eingangs genannten Art zu schaffen, bei dem bei ausreichender Variationsmöglichkeit der untersuchten Schicht des Untersuchungsobjektes der Aufwand für die Ansteuerung der Gradientenspulen gering gehalten ist.

Diese Aufgabe ist erfindungsgemäß dadurch gelöst, daß die Steuervorrichtung folgende Einrichtungen enthält :

— erste Einstellmittel zur Auswahl eines Steuersignales aus einer Anzahl von unterschiedlichen ersten Steuersignalen, welche jeweils einer solchen Position der untersuchten Schicht zugeordnet sind, in der eine Koordinatenachse in der Schichtebene verläuft,

— zweite Einstellmittel zur Auswahl eines Steuersignales aus einer Anzahl von unterschiedlichen zweiten Steuersignalen, welche jeweils einem Drehwinkel der Schichtebene um die in ihr verlaufende Koordinatenachse zugeordnet sind,

— eine Schaltung zur Steuerung der Speisung der Gradientenspulen nach Maßgabe des jeweils ausgewählten ersten und zweiten Steuersignales zwecks Festlegung der untersuchten Schicht auf die diesen ausgewählten Steuersignalen zugeordneten Position und den Drehwinkel.

Bei dem erfindungsgemäßen Gerät ist auf die beliebige Wahl der untersuchten Schicht verzichtet. Die untersuchte Schicht liegt immer in einer Ebene, die durch eine der drei zueinander senkrecht stehenden Achsen eines Koordinatensystems geht. Diese Ebene kann jedoch in ihrer Neigung verändert werden. Die so festgelegten Einstellmöglichkeiten reichen in der Praxis für die Schichtwahl aus. Die Steuervorrichtung kann dabei einen Rechner enthalten, der die erforderlichen Signale für die Gradientenspulen aus den eingestellten Werten ermittelt.

Die Erfindung ist nachfolgend anhand eines in der Zeichnung dargestellten Ausführungsbeispieles näher erläutert. Es zeigen :

Figur 1   eine Gesamtansicht eines Gerätes nach der Erfindung, und

Figur 2   eine Einzelheit des Gerätes gemäß Figur 1.

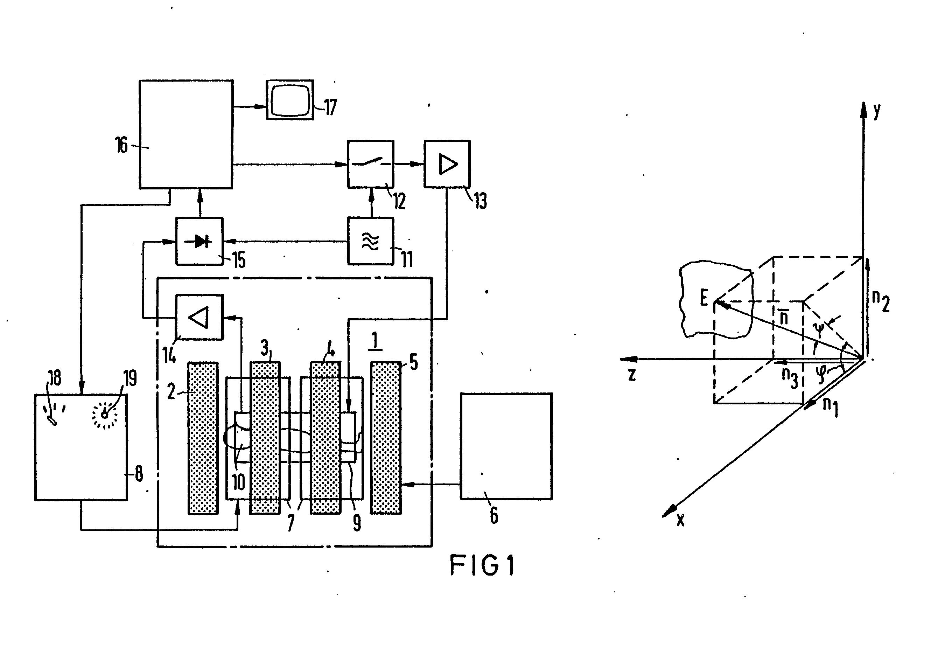

In der Figur 1 ist ein Spulensystem 1 dargestellt, das vier Magnetspulen 2, 3, 4, 5 aufweist, die von einem Magnetnetzgerät 6 gespeist sind und ein homogenes Magnetfeld in z-Richtung erzeugen. Zur Erzeugung eines Feldgradienten dienen Gradientenspulen 7, die von einer Steuervorrichtung 8 gespeist werden. Aufgrund des erzeugten Feldgradienten wird bei Zuführung eines Hochfrequenzimpulses zu einer Hochfrequenzspule 9 die Kernresonanz nur in einer bestimmten Schicht eines im Spulensystem liegenden Patienten 10 angeregt. Dies ist deshalb der Fall, weil zu jeder Frequenz des Anregungsimpulses eine bestimmte magnetische Flußdichte gehört und nur dort, wo diese Flußdichte auch herrscht, die Anregung erfolgt. Die Anregungsimpulse werden durch einen Hochfrequenzoszillator 11 erzeugt und der Hochfrequenzspule 9 über einen Modulator 12 und einen Sendeverstärker 13 zugeführt.

Nach dem Ende eines Anregungsimpulses werden die erzeugten Kernspins durch die Hochfrequenzspule 9 ausgelesen und entsprechende Signale über einen Signalverstärker 14 und einen phasenempfindlichen Gleichrichter 15 einem Prozeßrechner 16 zugeführt. Der phasenempfindliche Gleichrichter 15 wird vom Hochfrequenzoszillator 11 hierzu nach dem Ende eines Hochfrequenzimpulses entsprechend aktiviert. Aufgrund des erzeugten Feldgradienten können die ausgelesenen Frequenzen bestimmten Orten in der untersuchten Schicht des Patienten 10 zugeordnet werden. Ändert man die Richtung des Feldgradienten, so ist es möglich, aus den ausgelesenen Signalen ein Bild der untersuchten Schicht mit Hilfe des Prozeßrechners 16 zu berechnen und auf einem Monitor 17 wiederzugeben.

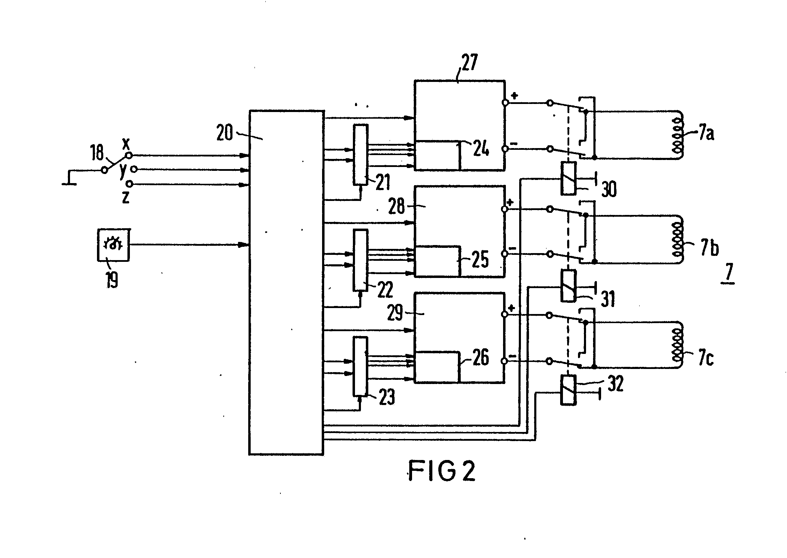

Die Ebene, in der jeweils eine Schicht des Patienten 10 untersucht wird, ist bei dem dargestellten Gerät dadurch festgelegt, daß sie durch eine der Achsen x, y oder z geht. Die z-Achse verläuft dabei in Längsrichtung der Öffnung im Spulensystem 1, in der der Patient 10 liegt, die y-Achse senkrecht dazu in der Zeichenebene, die x-Achse ebenfalls senkrecht dazu und senkrecht zur Zeichenebene. Zusätzlich ist es noch möglich, die Neigung der Ebene, in der die untersuchte Schicht liegt, durch Drehung um ihre jeweilige Achse x, y oder z einzustellen. Anhand der Figur 2 ist dies nachfolgend näher erläutert.

In der Figur 2 ist ein Schalter 18 dargestellt, der es erlaubt, die Achse x, y oder z, durch die die Ebene geht, auszuwählen. Ferner ist ein Winkelwähler 19 vorhanden, durch den die gewählte Ebene um ihre Achse drehbar und damit ihre Neigung einstellbar ist. Den eingestellten Werten entsprechende Signale werden einem Rechner 20 zugeführt, der daraus die den Gradientenspulen 7 zuzuführenden Signale zur entsprechenden Anregung und Auslesung bestimmt. Die Gradientenspule 7a ist dabei der x-Achse, die Gradientenspule 7b der y-Achse und die Gradientenspule 7c der z-Achse zugeordnet.

Die Ausgangssignale des Rechners 20 werden über Pufferspeicher 21 bis 23 Digital-Analog-Konvertern 24, 25, 26 in der x-Gradientenelektronik 27, in der y-Gradientenelektronik 28 und in der z-Gradientenelektronik 29 zugeführt. An den Elektroniken 27 bis 29 liegen für die Speisung der Gradientenspulen 7a, 7b und 7c geeignete Spannungen, die durch diese Elektroniken 27 bis 29 über Umpolrelais 30, 31, 32 den Gradientenspulen 7a, 7b, 7c zugeführt werden. Die Umpolsignale werden ebenfalls vom Rechner 20 geliefert.

Die Figur 2 zeigt die genaue Ausführung der Gradienten-Stromversorgung 8. Aus ihr geht die Einstellung der Neigung der gewählten Ebene und damit der untersuchten Schicht des Patienten 1 und die Wahl der Achse, durch die diese Ebene gehen soll, hervor. Aufgrund der Einschränkung in der Wählbarkeit der Ebene, in der die untersuchte Schicht liegt, auf eine von drei Achsen, ergibt sich ein einfacher Aufbau der Gradienten-Stromversorgung 8.

Für die Programmierung des Rechners 20 ist folgendes zu beachten :

Die Transformations-Matrix zur Abbildung der Gradienten-Vektoren $g_x$, $g_y$, $g_z$ in die Gradienten-Vektoren $g_{e1}$, $g_{e2}$, $g_{e3}$ in einem neuen Orthnormal-System mit den Achsen $\overline{e}_1$, $\overline{e}_2$, $\overline{e}_3$ läßt sich durch folgende Maßnahmen vereinfachen :

Festlegung des Winkels auf $\varphi = \pm \pi/2$, d. h. $\cos \varphi = 0$, $\sin \varphi = \pm 1$. Dies bedeutet bei

$$\overline{n} = \overline{e}_3 = \begin{pmatrix} 0 \\ \pm \cos \psi \\ \sin \psi \end{pmatrix},$$

daß nur um die x-Achse drehbare Schichtebenen zugelassen werden.

Nutzung der Tatsache, daß $\overline{n}$ und $- \overline{n}$ dieselbe Schnittebene ergeben. Die so entstehenden Bilder sind seitenverkehrt, können aber per Software « umgedreht » werden.

Einschränkung des Wertebereiches für $\psi$ auf $\pi/4 \leqslant \psi \leqslant \pi/2$. Dies führt bei der Festlegung von

$$\overline{e}_3 = \overline{n} = \begin{pmatrix} 0 \\ \pm \cos \psi \\ \sin \psi \end{pmatrix}$$

dazu, daß $\overline{e}_3$ mit der Hauptkomponente in z-Richtung weist.

Permutation der Zuordnung zwischen den $g_x$-, $g_y$- und $g_z$-Signalen und den x-, y- und z-Gradientenspulen. Damit ist zu erreichen,

a) daß die Einschränkung des Wertebereiches für $\psi$ aufgelöst wird (im bisher gewählten Beispiel $\overline{e}_3 \sim \overline{z}$ wird durch Erweiterung auf $\overline{e}_3 \sim Y$ die volle 180°-Drehung der Schnittebene um die x-Achse möglich),

b) daß die (in den bisherigen Beispielen vorgegebene) Sonderstellung der z-Achse auch auf die x- und y-Achse übertragen werden kann. Damit ist auch die 180°-Rotation der Schichtebene um die y- oder z-Achse möglich.

Die Transformations-Matrix vereinfacht sich durch Einsetzen der Werde für $\varphi = \pm \pi/2$ und mit dem Winkel $\psi^* = |90° - \psi|$ zu

$$\begin{pmatrix} g_{e1} \\ g_{e2} \\ g_{e3} \end{pmatrix} = \begin{pmatrix} 1 & 0 & 0 \\ 0 & \cos \psi^* & \mp \sin \psi^* \\ 0 & \pm \sin \psi^* & \cos \psi^* \end{pmatrix} \cdot \begin{pmatrix} g_x \\ g_y \\ g_z \end{pmatrix}$$

Der Winkel $\psi^*$ ist dabei stets positiv und ist bildlich der Winkel zwischen $\bar{z}$ und $\bar{e}_3$, während $\psi$ bei den räumlichen Polarkoordinaten den Winkel zwischen $\bar{e}_3$ bzw. $\bar{n}$ und der x-y-Ebene bedeutet. Die Vorzeichen bei den $\sin \psi^*$-Werten leiten sich aus $\varphi = \pm \pi/2 \rightarrow \sin \varphi = \pm 1$ her.

$\bar{n}$ ist dabei ein Normalen-Vektor, der auf der gewählten Ebene senkrecht steht und durch den Ursprung des x-, y-, z-Koordinatensystems geht. Die Richtung von $\bar{e}_1$ wird zweckmäßig als Richtung der Schnittgeraden zwischen gewählter Ebene und x-z-Ebene definiert. $\bar{e}_2$ ist dann durch die Forderung nach positiver Orientierung des Systems $\bar{e}_1$, $\bar{e}_2$, $\bar{e}_3$ bestimmt.

Für den Winkel $\psi^*$ kann ein Vorzeichen dadurch vereinfacht werden, daß $\psi^* > 0$ zu positiven und $\psi^* < 0$ zu negativen y-Komponenten bei $\bar{e}_3$ führen. Man erhält so für die Vorzeichen in der Transformations-Matrix eindeutige Verhältnisse, ohne auf die Bedeutung des nicht mehr erscheinenden Winkels $\varphi$ zurückgreifen zu müssen:

$$\begin{pmatrix} g_{e1} \\ g_{e2} \\ g_{e3} \end{pmatrix} = \begin{pmatrix} 1 & 0 & 0 \\ 0 & \cos \psi^* & -\sin \psi^* \\ 0 & \sin \psi^* & \cos \psi^* \end{pmatrix} \cdot \begin{pmatrix} g_x \\ g_y \\ g_z \end{pmatrix}$$

bzw. in Kurzschreibweise

$$\bar{G}_e = \bar{T} \cdot \bar{G}_{xyz}.$$

Achsenpermutationen

Die Permutation

$$\begin{pmatrix} g_x \\ g_y \\ g_z \end{pmatrix} \rightarrow \begin{pmatrix} g_x \\ g_z \\ g_y \end{pmatrix}$$

werde in Kurzform mit $\bar{G}_{xyz} \rightarrow \bar{G}_{xyz}$ bezeichnet. Es ergeben sich folgende mögliche Fälle :

I. Drehung der Ebene um die x-Achse :

$\bar{G}_e = T \cdot \bar{G}_{xyz}, \; \psi^* : \sphericalangle (\bar{z} \rightarrow \bar{e}_3)$
$\bar{G}_e = T \cdot \bar{G}_{xzy}, \; \psi^* : \sphericalangle (\bar{y} \rightarrow \bar{e}_3)$

II. Drehung der Ebene um die y-Achse :

$\bar{G}_e = T \cdot \bar{G}_{xyz}, \; \psi^* : \sphericalangle (\bar{z} \rightarrow \bar{e}_3)$
$\bar{G}_e = T \cdot \bar{G}_{yzx}, \; \psi^* : \sphericalangle (\bar{x} \rightarrow \bar{e}_3)$

III. Drehung der Ebene um die z-Achse :

$\bar{G}_e = T \cdot \bar{G}_{zxy}, \; \psi^* : \sphericalangle (\bar{y} \rightarrow \bar{e}_3)$
$\bar{G}_e = T \cdot \bar{G}_{zyx}, \; \psi^* : \sphericalangle (\bar{x} \rightarrow \bar{e}_3)$

Randbedingungen für verfahrenstechnische Pulssequenzen

Die Pulssequenzen für die Gradientenfelder zur Messung von Bilddaten sind auf die Koordinatenachsen $\bar{e}_1$, $\bar{e}_2$ und $\bar{e}_3$ anzuwenden. Zur Vermeidung von Umschaltvorgängen bei den technischen Gradientenpulsen $g_x$, $g_y$ und $g_z$ während solcher Pulse lassen sich aus der Transformations-Matrix T folgende Bedingungen ablesen :

$g_{e1}$ ist zeitlich beliebig mit den übrigen Gradienten $g_{e2}$ und $g_{e3}$ kombinierbar.

$g_{e2}$ und $g_{e3}$ können nur kombiniert werden, wenn beide gleichzeitig ein- und ausgeschaltet werden.

Mit geeignetem Pulsschema lassen sich auch bei Drehung der Schnittebene um eine der Achsen x, y oder z Bilder erzeugen. Dazu genügt eine Polarität bei der Gradienten-Stromversorgung, wobei aber vor bestimmten Impulsen durch Schaltelemente eine Polvertauschung vorgenommen werden muß.

**Patentansprüche**

1. Gerät zur Erzeugung von Bildern eines Untersuchungsobjektes (10) mit magnetischer Kernspinresonanz, bei dem Mittel (1) zum Anlegen von Magnetfeldern an das Untersuchungsobjekt (10) und Mittel (9, 11 bis 17) zum Erfassen der Auslenkung der Kernspins des Untersuchungsobjektes (10) aus ihrer

4

Gleichgewichtslage durch einen hochfrequenten magnetischen Anregungsimpuls vorhanden sind und bei dem die Mittel (1) zum Anlegen von Magnetfeldern Gradientenspulen (7a, 7b, 7c) aufweisen, die von einer Steuervorrichtung (8) gespeist werden und die Lage einer untersuchten Schicht im Untersuchungsobjekt (10) in bezug auf ein dreidimensionales Koordinatensystem mit einer x-, y- und z-Achse festlegen, dadurch gekennzeichnet, daß die Steuervorrichtung (8) folgende Einrichtungen enthält :

— erste Einstellmittel (18) zur Auswahl eines Steuersignales aus einer Anzahl von unterschiedlichen ersten Steuersignalen, welche jeweils einer solchen Position der untersuchten Schicht zugeordnet sind, in der eine Koordinatenachse in der Schichtebene verläuft,

— zweite Einstellmittel (19) zur Auswahl eines Steuersignales aus einer Anzahl von unterschiedlichen zweiten Steuersignalen, welche jeweils einem Drehwinkel der Schichtebene um die in ihr verlaufende Koordinatenachse zugeordnet sind,

— eine Schaltung (20 bis 29) zur Steuerung der Speisung der Gradientenspulen (7a, 7b, 7c) nach Maßgabe des jeweils ausgewählten ersten und zweiten Steuersignales zwecks Festlegung der untersuchten Schicht auf die diesen ausgewählten Steuersignalen zugeordnete Position und den Drehwinkel.

2. Gerät nach Anspruch 1, dadurch gekennzeichnet, daß die Schaltung (20 bis 29) einen Rechner (20) umfaßt, der die den Gradientenspulen (7a, 7b, 7c) zuzuführenden Signale festlegt.

3. Gerät nach Anspruch 1, dadurch gekennzeichnet, daß die Schaltung (20 bis 29) nur eine Ausgangspolarität erzeugt und durch nachgeschaltete Umpoleinrichtungen (30, 31, 32) ergänzt ist.

## Claims

1. Apparatus for producing images of an object under examination (10) by nuclear magnetic resonance, wherein are provided means (1) for connecting magnetic fields to the object (10) under examination and means (9, 11 to 17) for detecting any deflection of the core spins of the object (10) under examination from their position of equilibrium by means of a high-frequency magnetic excitation pulse, and wherein the means (1) for connecting magnetic fields have gradient coils (7a, 7b, 7c) which are fed by a control device (8) and determine the position of an examined layer in the object (10) under examination in respect of a three-dimensional coordinate system having x, y and z axes, characterised in that the control device (8) comprises the following facilities :

— first setting means (18) for selecting a control signal from a number of different first control signals respectively assigned to a position of the examined layer un which an axis of coordinates extends in the layer plane ;

— second setting means (19) for selecting a control signal from a number of different second control signals respectively assigned to an angle of rotation of the layer plane about the axis of coordinates which extends therein ;

— a circuit (20 to 29) for controlling the supply of the gradient coils (7a, 7b, 7c) in accordance with the respectively selected first and second control signal for the purpose of determining the examined layer at the position assigned to the selected control signals and angle of rotation. -

2. Apparatus as claimed in Claim 1, characterised in that the circuit (20 to 29) comprises a computer (20) which determines the signals to be supplied to the gradient coils (7a, 7b, 7c).

3. Apparatus as claimed in Claim 1, characterised in that the circuit (20 to 29) produces only one output polarity, and is supplemented by following pole-reversal devices (30, 31, 32).

## Revendications

1. Appareil de production d'images d'un objet à examiner (10) par résonnance magnétique nucléaire dans lequel sont prévus des moyens (1) pour appliquer des champs magnétiques à l'objet à examiner (10), et des moyens (9, 11 à 17) pour détecter la déviation du spin nucléaire de l'objet à examiner (10) par rapport à sa position d'équilibre, sous l'effet d'une impulsion d'excitation magnétique de haute fréquence, et dans lequel les moyens (1), pour appliquer des champs magnétiques, comportent des bobines de gradients (7a, 7b, 7c) qui sont alimentées par un dispositif de commande (8) et qui déterminent la position d'une couche à examiner dans l'objet à examiner (10), par rapport à un système de coordonnées à trois dimensions ayant des axes x, y et z, caractérisé en ce que le dispositif de commande (8) contient les dispositifs suivants :

— des premiers moyens de réglage (18) pour choisir un signal de commande parmi un certain nombre de premiers signaux de commande différents associés chacun à une position telle de la couche à examiner, qu'un axe de coordonnées se trouve dans le plan de la couche,

— des seconds moyens de réglage (19) pour choisir un signal de commande parmi un certain nombre de seconds signaux de commande différents associés chacun à un angle de rotation du plan de couche autour de l'axe de coordonnées qui se trouve dans ce plan,

— un circuit (20 à 29) pour commander l'alimentation des bobines de gradients (7a, 7b, 7c), en fonction des premiers et seconds signaux de commande choisis, en vue de fixer la couche à examiner sur la position et sur l'angle de rotation associés à ces signaux de commande choisis.

2. Appareil suivant la revendication 1, caractérisé en ce que le circuit (20 à 29) comprend une calculatrice (20) qui détermine les signaux à envoyer aux bobines de gradients (7a, 7b, 7c).

3. Appareil suivant la revendication 1, caractérisé en ce que le circuit (20 à 29) ne produit qu'une polarité de sortie et est complété par des dispositifs d'inversion de polarité (30, 31, 32) montés en aval.

FIG 1

FIG 2